# EUROPÄISCHE PATENTANMELDUNG

(11) **EP 4 668 152 A1**
(43) Veröffentlichungstag der Anmeldung: **24.12.2025**
(21) Anmeldenummer: 24183111.4
(22) Anmeldetag: 19.06.2024
(51) Int. Cl.: G06F 30/15, G01S 7/40, G01S 13/89, G01S 13/931, G06F 30/20, G09B 9/54

(54) **SIMULATOR UND VERFAHREN ZUR SIMULATION EINES SENSORS ZUR OBJEKTERFASSUNG**

(71) Anmelder: dSPACE GmbH, 33102 Paderborn (DE)
(72) Erfinder: Brodehl, Christoph, 33102 Paderborn (DE); Glarner, Thomas, 33102 Paderborn (DE)

(57) **Zusammenfassung**

Die Anmeldung betrifft einen Simulator (10) zur Simulation eines Sensors zur Objekterfassung, wobei der Simulator (10) eingerichtet ist, mittels der Simulation synthetische Sensordaten (32) des Sensors zu erzeugen. Der Simulator (10) weist auf:
ein Sichtbarkeits-Modul (12), das eingerichtet ist, für zumindest ein virtuelles Objekt (O1-O6), das sich in einer virtuellen Umgebung (30) befindet, in Abhängigkeit von dem Sensor Objektdaten (22) zu erzeugen,
ein Abbildungs-Modul (14), das eingerichtet ist, zumindest zwei Parameter des virtuellen Objektes (O1-O6) aus den Objektdaten (22) zu ermitteln und das zumindest eine virtuelle Objekt (O1-O6) in Abhängigkeit von den zumindest zwei Parametern in einer ersten Zuordnungs-Abbildung (24) darzustellen,
ein Verknüpfungs-Modul (16), das eingerichtet ist, die erste Zuordnungs-Abbildung (24) unter Berücksichtigung einer charakteristischen Funktion (46) des Sensors in eine zweite Zuordnungs-Abbildung (26) zu überführen, wobei in der zweiten Zuordnungs-Abbildung (26) das zumindest eine virtuelle Objekt (O1-O6) in Abhängigkeit von den zumindest zwei Parametern dargestellt ist,
ein Ausgabe-Modul (20), das eingerichtet ist, die zweite Zuordnungs-Abbildung (26) in die synthetische Sensordaten (32) zu konvertieren und die synthetischen Sensordaten (32) zur Ausgabe bereitzustellen.

Die Anmeldung betrifft weiter ein Verfahren zur Simulation eines Sensors zur Objekterfassung sowie ein Computerprogrammprodukt.

## Beschreibung

### Technisches Gebiet

Die Anmeldung betrifft einen Simulator und ein Verfahren zur Simulation eines Sensors zur Objekterfassung sowie ein Computerprogrammprodukt.

### Hintergrund

Geräte zur Ausführung von Steuerungs- und/oder Regelungsaufgaben in Fahrzeugen werden auch als Steuergeräte bezeichnet. Steuergeräte in Fahrzeugen, insbesondere Kraftfahrzeugen, können eine Recheneinheit, Speicher, Schnittstellen und evtl. weitere Komponenten, aufweisen, die für die Verarbeitung von Eingangssignalen mit Eingangsdaten in das Steuergerät und die Erzeugung von Steuersignalen mit Ausgangsdaten erforderlich sind. Die Schnittstellen dienen zur Aufnahme der Eingangssignale bzw. Abgabe der Steuersignale.

Steuergeräte für Fahrfunktionen sowohl für fortgeschrittene Fahrerassistenzsysteme (ADAS = Advanced Driver Assistance Systems) als auch für autonomes oder teilautonomes Fahren, können als Eingangsdaten Sensordaten von verschiedenen Sensoren, z. B. von Sensoren zur Objekterfassung, erhalten.

Eine Möglichkeit zum Test von Steuergeräten, die Sensordaten von Sensoren auswerten, besteht darin, die Steuergeräte mit den entsprechenden Sensoren im Einbauzustand - beispielsweise im Kraftfahrzeug im Rahmen von Testfahrten - zu erproben. Dies ist aufwendig, kostenintensiv und es können viele Situationen in einer echten Umgebung nicht überprüft werden, da sie nur in Extremfällen, beispielsweise bei Unfällen, auftreten. Deshalb werden entsprechende Steuergeräte in künstlichen Umgebungen, beispielsweise in Prüfständen, getestet. Ein weiteres häufiges Testszenario besteht hier darin, die Funktionalität eines Steuergeräts mittels einer simulierten Umwelt in einer sogenannten virtuellen Umgebung zu testen. Die Umgebungssimulation kann dabei die Simulation von realen Sensoren mittels einer Sensorsimulation umfassen. Die Sensorsimulation kann dabei synthetische Sensordaten generieren, die die virtuelle Umgebung des Steuergerätes nachbilden.

Aus Stefan O. Wald, Frank Weinmann: Ray Tracing for Range-Doppler Simulation of 77GHz Automotive Scenarios, 13th European Conference On Antennas and Propagation (2019) ist es bekannt, dass ein sogenanntes Ray Tracing genutzt wird, um eine Entfernungs-Doppler-Abbildung zu bestimmen. Dabei wird in einer virtuellen Umgebung ein Ausbreitungsweg analytisch berechnet, indem die Positionen des Senders, der Streuzentren und des Empfängers verwendet werden. Damit können dann synthetische Entfernungs-Doppler-Abbildungen ermittelt und weiterverwendet werden.

### Übersicht

Ein Simulator zur Simulation eines Sensors zur Objekterfassung ist eingerichtet, mittels einer Simulation synthetische Sensordaten des Sensors zur Objekterfassung zu erzeugen. Der Simulator weist ein Sichtbarkeits-Modul, ein Abbildungs-Modul, ein Verknüpfungs-Modul und ein Ausgabe-Modul auf.

Das Sichtbarkeits-Modul ist eingerichtet, für zumindest ein virtuelles Objekt, das sich in einer virtuellen Umgebung befindet, in Abhängigkeit von dem Sensor Objektdaten zu erzeugen.

Das Abbildungs-Modul ist eingerichtet, zumindest zwei Parameter des virtuellen Objektes aus den Objektdaten zu ermitteln und das zumindest eine virtuelle Objekt in Abhängigkeit von den zumindest zwei Parametern in einer ersten Zuordnungs-Abbildung darzustellen.

Das Verknüpfungs-Modul ist eingerichtet, die erste Zuordnungs-Abbildung unter Berücksichtigung einer charakteristischen Funktion des Sensors in eine zweite Zuordnungs-Abbildung zu überführen, wobei in der zweiten Zuordnungs-Abbildung das zumindest eine virtuelle Objekt in Abhängigkeit von den zumindest zwei Parametern dargestellt ist.

Das Ausgabe-Modul ist eingerichtet, die zweite Zuordnungs-Abbildung in die synthetischen Sensordaten zu konvertieren und die synthetischen Sensordaten zur Ausgabe bereitzustellen.

Ein Verfahren zur Simulation eines Sensors zur Objekterfassung erzeugt synthetische Sensordaten des Sensors. Das Verfahren weist auf:
- Erzeugen von Objektdaten für zumindest ein virtuelles Objekt, das sich in einer virtuellen Umgebung befindet. Die Erzeugung der Objektdaten erfolgt in Abhängigkeit von dem Sensor zur Objekterfassung.
- Ermitteln von zumindest zwei Parametern des virtuellen Objektes aus den Objektdaten und Darstellen des zumindest einen virtuellen Objektes in Abhängigkeit von den zumindest zwei Parametern in einer ersten Zuordnungs-Abbildung.
- Überführen der ersten Zuordnungs-Abbildung unter Berücksichtigung einer charakteristischen Funktion des Sensors in eine zweite Zuordnungs-Abbildung, wobei in der zweiten Zuordnungs-Abbildung das zumindest eine virtuelle Objekt in Abhängigkeit von den zumindest zwei Parametern dargestellt ist.
- Konvertieren der zweiten Zuordnungs-Abbildung in die synthetischen Sensordaten und Bereitstellen der synthetischen Sensordaten zur Ausgabe.

Ein Computerprogrammprodukt umfasst die Befehle, die bei der Ausführung eines Programms durch einen Computer diesen veranlassen, die Schritte des beschriebenen Verfahrens auszuführen.

Mittels des beschriebenen Simulators und der beschriebenen Vorrichtung lassen sich die erzeugten synthetischen Sensordaten noch besser an die Anforderungen anpassen, welche an synthetische Sensordaten gestellt werden.

Durch den Simulator zur Simulation des Sensors zur Objekterfassung und das Verfahren zur Simulation des Sensors zur Objekterfassung kann eine echtzeitfähige Berechnung von teilprozessierten Sensordaten ermöglicht werden. Die zur Ausgabe bereitgestellten synthetischen Sensordaten können synthetische Sensordaten darstellen, welche Daten simulieren, die innerhalb des Sensors als teilprozessierte Sensordaten vorliegen. Hierdurch ist es möglich, auch solche teilprozessierten Sensordaten als Teil der synthetischen Sensordaten zur Verfügung zu stellen und innerhalb einer Simulation, welche die synthetischen Sensordaten verwendet, weiter zu verarbeiten.

Der Simulator und das Verfahren können dabei ohne die Simulation konkreter detaillierter technischer Abläufe im Sensor auskommen. Es ist lediglich notwendig, die den Sensor charakterisierende charakteristische Funktion bereitzustellen. Diese ist jedoch z. B. messbar und benötigt nicht eine Preisgabe von Know-how über den konkreten detaillierten technischen Aufbau des Sensors durch einen jeweiligen Sensorhersteller.

Der Simulator zur Simulation des Sensors zur Objekterfassung kann die Verwendung eines tatsächlichen Sensors zur Objekterfassung vermeiden, was Testaufwände verringern kann. Der Sensor zur Objekterfassung kann z. B. einen Radarsensor, einen Lidarsensor, eine Kamera und/oder einen Ultraschallsensor aufweisen. Der Simulator simuliert bestimmungsgemäß einen solchen Sensor.

Der Simulator erzeugt anhand einer virtuellen Umgebung mit mindestens einem virtuellen Objekt die synthetische Sensordaten, die dann für eine weitere Verarbeitung verwendet werden können. Damit ist kein Prüfaufbau mit einem Sensor und einem Objektsimulator mehr notwendig, sondern der Sensor und die von ihm erzeugten synthetischen Sensordaten können anhand einer virtuellen Umgebung mit virtuellen Objekten auf einem Rechner oder mehreren Rechnern simuliert werden. Daher weist der Simulator ein oder mehrere Rechner bzw. entsprechende Computer und/oder Prozessoren mit entsprechendem Speicher und Eingabe- und Ausgabeschnittstellen auf.

Die synthetischen Sensordaten, die durch die Simulation des Sensors erzeugt werden, sollen idealerweise ununterscheidbar von den Sensordaten sein, wie sie der Sensor, beispielsweise ein Radarsensor, erzeugt. Die synthetischen Sensordaten können dann z. B. durch das Steuergerät und/oder eine Simulation des Steuergerätes weiterverarbeitet werden.

Das Sichtbarkeits-Modul erzeugt für die virtuelle Umgebung mit mindestens einem virtuellen Objekt die Objektdaten, die der Sensor in einer wirklichen Umgebung mit wirklichen Objekten erzeugt hätte. Das Sichtbarkeits-Modul kann daher als eine Softwarefunktion ausgebildet sein. Das Sichtbarkeits-Modul kann auch auf einem oder mehreren dieser Softwarefunktion zugeordneten Prozessoren, beispielsweise auch Grafikprozessoren, ablaufen.

Auch das Abbildungs-Modul kann als ein Softwaremodul ausgebildet sein. Es erzeugt die erste Zuordnungs-Abbildung mit mindestens zwei Parametern des virtuellen Objekts aus den Objektdaten. Wenn zwei Parameter verwendet werden, kann die erste Zuordnungs-Abbildung als ein zweidimensionales Diagramm aufgefasst werden, das die zwei Parameter auf einen Funktionswert abbildet. Werden mehr als zwei Parameter verwendet, liegt eine entsprechend höherdimensionale erste Zuordnungs-Abbildung vor.

Die erste Zuordnungs-Abbildung ist eine Darstellung, wie sie durch die erste Zuordnungs-Abbildung aus den Objektdaten ermittelt wurde. In der ersten Zuordnungs-Abbildung fehlen noch Charakteristiken des Sensors. Diese werden durch das Verknüpfungs-Modul eingefügt, das ebenfalls als eine Softwarefunktion ausgebildet sein kann. Das Verknüpfungs-Modul verwendet die erste Zuordnungs-Abbildung und die charakteristische Funktion des Sensors, um die zweite Zuordnungs-Abbildung zu ermitteln.

Die charakteristische Funktion des Sensors spiegelt Eigenschaften dieses Sensors wider. D. h. sie kann anhand von zugeführten Testdaten aus Ausgabedaten des Sensors ermittelt werden. Durch die zweite Zuordnungs-Abbildung liegt daher eine realistischere Darstellung durch die zumindest zwei Parameter des zumindest einen virtuellen Objekts vor. Damit können dann Effekte berücksichtigt werden, die beispielsweise durch Randeffekte, Abbildungsartefakte oder andere wirklichkeitsgetreue Eigenschaften des Sensors bedingt sind.

Das Ausgabemodul kann eine Softwarefunktionen sein, die die zweite Zuordnungs-Abbildung in synthetische Sensordaten überführt und zur Ausgabe bereitstellt. Mit diesen synthetischen Sensordaten ist es dann möglich, weitere Verarbeitungsschritte z. B. zum Testen von Steuergeräten durchzuführen.

Entsprechendes gilt für das Verfahren und das Computerprogrammprodukt.

In einer Ausführungsform kann die erste Zuordnungs-Abbildung eine erste Entfernungs-Doppler-Abbildung aufweisen und die zweite Zuordnungs-Abbildung kann eine zweite Entfernungs-Doppler-Abbildung aufweisen. In der Entfernungs-Doppler-Abbildung wird in einem zweidimensionalen Graphen die Entfernung von Objekten über deren relativer Geschwindigkeit zum Sensor aufgetragen. Die zwei Parameter sind also Entfernung und relative Geschwindigkeit. Die erste Entfernungs-Doppler-Abbildung wird also durch das Verknüpfungs-Modul in die zweite Entfernungs-Doppler-Abbildung überführt.

Die Messung einer Dopplerverschiebung bietet eine Möglichkeit zur unmittelbaren Geschwindigkeitsmessung, z. B. eines am Objekt reflektierten Sensorsignals, z. B. eines Radarechos oder eines Lidarechos. Bewegt sich bspw. ein Objekt auf den Sensor zu, ist die Frequenz des Echosignals des Objekts gegenüber dem ausgesandten Signal leicht erhöht. Umgekehrt bedeutet eine erniedrigte Frequenz, dass das Objekt sich vom Sensor fortbewegt. Die Dopplerverschiebung ist umso höher, je schneller sich das Objekt relativ zum Sensor bewegt und erlaubt dadurch einen direkten Rückschluss auf eine relative radiale Geschwindigkeit des Objekts.

Ein Beispiel für den Sensor zur Objekterfassung ist der frequenzmodulierte Dauerstrichradar (FMCW, Frequency Modulated Continuous Wave). Ein solcher FMCW-Radar sendet ein kontinuierliches Radarsignal, das Tastsignal, aus. Das Signal ist eine ununterbrochene, periodische Aneinanderreihung von Signalabschnitten mit veränderlicher Frequenz (Chirps). Die von Objekten reflektierten Signale sind dementsprechend zeitversetzte Chirps. Aus dem Zeitversatz und der sich ändernden Frequenz ergibt sich ein kleiner Frequenzunterschied zwischen Tastsignal und Echosignal. In einem Mischer des Radars wird das ausgesandte Signal, das Tastsignal, mit den Echosignalen überlagert. Dadurch entsteht für jedes Echosignal eine Schwebung mit einer Schwebefrequenz, wobei die Schwebefrequenz umso höher ist, je weiter das jeweilige Objekt vom Sensor entfernt ist. Aus der Schwebung bildet der Sensor die Fourier-Transformierte. In der Fourier-Transformierten ist jedes Echosignal, d. h. jedes reflektierte Objekt, als ein Peak sichtbar, der der jeweiligen Schwebefrequenz entspricht, und aus dessen Position auf der Frequenzachse unmittelbar auf die Entfernung des Objekts geschlossen werden kann.

Eine Fourier-Transformierte wird durch den Sensor für jeden einzelnen Chirp bestimmt. Die einzelnen Ergebnisse dieser Fourier-Transformation werden zusammengefügt. Dadurch ergibt sich eine zweidimensionale Entfernungs-Zeit-Abbildung mit der Entfernung in der Vertikalen und der Zeit in der Horizontalen. In der Vertikalen (Entfernung) sind die einzelnen Fourier-Transformierten aufgetragen. Entlang der horizontalen Achse sind dann eine Vielzahl von Fouriertransformierten in einer zeitlichen Sortierung aufgetragen.

Dann unterzieht der Sensor die Entfernungs-Zeit-Abbildung einer zweiten Fouriertransformation entlang der Zeitachse. Das Ergebnis ist die sogenannte Entfernungs-Doppler-Abbildung (engl. Range-Doppler-Map). In jeder Zeile des Entfernungs-Zeitdiagramm ändert sich die Phase der Werte entlang der Zeitachse. Die horizontale Position in der Entfernungs-Doppler-Abbildung gibt die Frequenz der Phasendurchläufe des Objektes an, d. h. die Phasenänderung in der Zeit. Diese Phasenänderung ist die Frequenzverschiebung des Radarechos durch die Relativbewegung des Objektes. Jeder Peak in der Entfernungs-Doppler-Abbildung steht also für ein vom Radar detektiertes Objekt. Aus der vertikalen Position des Peaks ist die Entfernung des Objekts auslesbar, aus der horizontalen Position seine radiale Relativgeschwindigkeit. Solch eine Entfernungs-Doppler-Abbildung kann auch beispielsweise bei einem Lidar-Sensor verwendet werden, wenn der Lidar-Sensor auf gleiche Weise nach dem FMCW-Prinzip funktioniert.

Insbesondere kann die charakteristische Funktion eine Punktspreizfunktion des Sensors aufweisen und das Verknüpfungs-Modul kann eingerichtet sein, die erste Zuordnungs-Abbildung unter Ausführung einer Faltungsfunktion mit der Punktspreizfunktion in die zweite Zuordnungs-Abbildung zu überführen. In einer Ausführungsform ist die charakteristische Funktion die Punktspreizfunktion des Sensors und die erste Entfernungs-Doppler-Abbildung wird durch eine Faltung mit der Punktspreizfunktion in die zweite Entfernungs-Doppler-Abbildung überführt.

Eine Punktspreizfunktion eines Sensors beschreibt beispielsweise in der Hochfrequenztechnik, wenn es sich bei dem Sensor um einen Radar handelt oder um einen Lidar in der Optik, aber auch in der Bildverarbeitung, die Wirkung von bandbegrenzenden Einflussfaktoren wie eine Beugungserscheinungen an Blenden, ein Abbildungsfehler oder ein Einfluss der Sensorfläche bzw. einer Apertur.

Die Punktspreizfunktion gibt an, wie ein idealisiertes, punktförmiges Objekt durch ein System (also den Sensor) abgebildet werden würde. Oft ist die Form der Antwort unabhängig vom ursprünglichen Ort des idealen punktförmigen Objekts. In diesem Fall spricht man von einem linearen System und die Gesamtantwort des Systems kann als Summe über die Punkteantworten des in seine Punkte zerlegten Objekts berechnet werden. Die Faltung bewirkt, dass jedes punktartige lokale Maximum in der ersten Zuordnungsabbildung durch einen der Punktspreizfunktion entsprechenden Funktionsverlauf ersetzt wird.

In einer Ausführungsform weist der Sensor zur Objekterfassung einen aktiven Sensor auf, welcher eingerichtet ist, Sensor-Rohdaten durch Aussenden eines Tastsignals und Empfangen eines Echosignals zu erzeugen und die zweite ZuordnungsAbbildung aus den Sensorrohdaten zu ermitteln. Ein aktiver Sensor ist ein Sensor, der zur Objekterfassung in seiner Umgebung ein Signal, auch Tastsignal genannt, aussendet, das von in der Umgebung befindlichen Objekten über ein Echosignal reflektiert wird. Über das Echosignal ist es dann möglich, die Objekte zu detektieren und über die Zeit auch in ihrer Relativbewegung zum Sensor zu beobachten. Aktive Sensoren umfassen demnach Radar-, Lidar- oder akustische Sensoren, die Tastsignale ausgeben und die entsprechen Echosignale dann auswerten.

In einer Ausführungsform ist ein Rückberechnungs-Modul vorgesehen, das als Softwarefunktion ausgebildet sein kann, wobei das Rückberechnungs-Modul aus der zweiten Zuordnungs-Abbildung synthetische Sensor-Rohdaten ermittelt, wobei die Ermittlung der synthetischen Sensor-Rohdaten von dem Sensor zur Objekterfassung abhängt. Der Zugriff auf synthetische Sensor-Rohdaten kann für die weitere Verarbeitung der synthetischen Sensordaten bei einer Simulation des Sensors zukünftig Bedeutung erlangen.

Mittels des Simulators oder des Verfahrens kann also die zweite Zuordnungs-Abbildung aus den Objektdaten ermittelt werden. Es ist also möglich, synthetische Sensordaten zur Ausgabe bereitzustellen, welche die Objektdaten und die zweite Zuordnungs-Abbildung aufweisen. Die Ermittlung von synthetischen Sensor-Rohdaten ist optional möglich, jedoch nicht zwingend. Ein Verzicht auf die Berechnung der synthetischen Sensor-Rohdaten ermöglicht eine effiziente und schnelle Berechnung und kostengünstige Implementierung.

In einer Ausführungsform weist die Ermittlung der synthetischen Sensor-Rohdaten durch das Rückberechnungs-Modul eine inverse Fourier-Transformation auf. Aus den Sensor-Rohdaten wird durch eine Fourier-Transformation die zweite Zuordnungs-Abbildung ermittelt. Daher kann für eine Rückberechnung eine inverse Fourier-Transformation verwendet werden.

In einer Ausführungsform ist dem simulierten Sensor in der virtuellen Umgebung eine virtuelle Position zugeordnet und die Objektdaten für das zumindest eine virtuelle Objekt zyklisch unter Berücksichtigung der jeweiligen virtuellen Position, z. B. durch das Sichtbarkeits-Modul, erzeugt werden.

Hierfür kann z. B. das sogenannte Ray Tracing eingesetzt werden, bei dem in der virtuellen Umgebung das Aussenden eines virtuellen Tastsignals und des jeweiligen virtuellen Echosignals an einem virtuellen Objekt berechnet werden. Die Objektdaten für ein jeweiliges virtuelles Objekt können eine Repräsentation des jeweiligen virtuellen Echosignals des jeweiligen virtuellen Tastsignals an dem jeweiligen virtuellen Objekt aufweisen.

Die synthetischen Sensordaten sind in Ausführungsformen des Simulators und des Verfahrens so ausgebildet, dass die Objektdaten durch den Sensor aus den synthetischen Sensordaten herleitbar sind. Die synthetischen Sensordaten sind also von einer Qualität, dass sie auch reale Sensordaten sein könnten und durch den realen Sensor verarbeitet werden könnten.

### Figurenliste

Ausführungsbeispiele der Erfindung sind in der Zeichnung dargestellt und werden in der nachfolgenden Beschreibung näher erläutert.

Es zeigen
**Figur 1** ein Blockschaltbild einer Simulationsumgebung,
**Figur 2** eine Umsetzung von Sensor-Objektdaten in eine zweite Zuordnungs-Abbildung,
**Figur 3** eine virtuelle Umgebung mit virtuellen Objekten,
**Figur 4** eine Entfernungs-Doppler-Abbildung aus Objektdaten,
**Figur 5** eine charakteristische Funktion,
**Figur 6** eine zweite Zuordnungs-Abbildung,
**Figur 7** eine Erzeugung der zweiten Zuordnungs-Abbildung und
**Figur 8** ein Flussdiagramm.

Es werden in den Figuren die gleichen Bezugszeichen für gleiche oder ähnliche Elemente verwendet. Die Darstellungen in den Figuren können nicht maßstäblich sein.

### Figurenbeschreibung

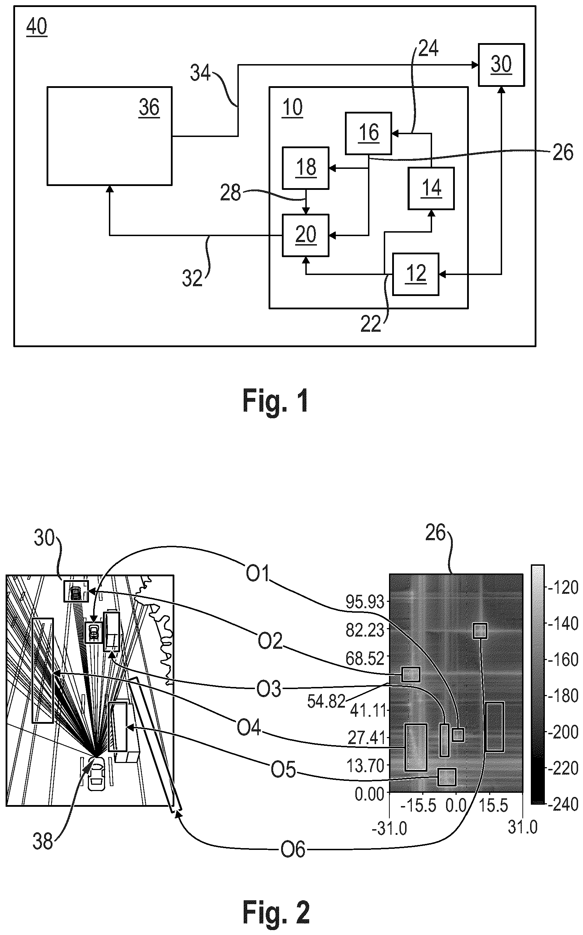

Figur 1 zeigt eine Simulationsumgebung 40, welche einen Simulator 10, eine virtuelle Umgebung 30 sowie eine Anwendung 36 aufweist. Der Simulator 10 ist ausgebildet, einen Sensor zur Objekterfassung wie einen Radar- oder Lidarsensor zu simulieren.

Die Anwendung 36 ist z. B. eine automatisierte Steuerung eines Fahrzeugs, auf dem der simulierte Sensor 38 angeordnet sein soll. Aber auch andere Fahrerassistenzfunktionen können solche Anwendungen 36 oder Applikationen sein. Die Anwendung 36 kann auch zumindest teilweise als Hardware ausgebildet sein und z. B. als Steuergerät oder zumindest Teil eines Steuergerätes ausgebildet sein.

Dieser Aufbau der Simulationsumgebung 40 gemäß Figur 1 kann rein virtuell sein und z. B. auf einem oder mehreren Rechnern ablaufen. Damit kann ohne einen zeit- und kostenintensiven Versuchsaufbau die Signalverarbeitung simuliert werden und/oder Anwendungen 36 wie z. B. Fahrfunktionen getestet werden.

Der Aufbau der Simulationsumgebung 40 gemäß Figur 1 kann auch teilweise in Hardware und teilweise in Software ausgeführt sein.

In der virtuellen Umgebung 30 können gewünschte Szenarien mit einem oder mehreren virtuellen Objekten 01-06 dargestellt werden. Auch wie sich diese virtuelle Objekte 01-06 relativ zum simulierten Sensor 38 bewegen, kann realitätsnah simuliert werden. Insbesondere kann die Anwendung 36 z. B. über die Anwendungsdaten und die synthetischen Sensordaten 32 mit der virtuellen Umgebung 30 interagieren.

Der Simulator 10 weist ein Sichtbarkeits-Modul 12 auf, das für zumindest ein virtuelles Objekt 01-06 in der virtuellen Umgebung 30 in Abhängigkeit von dem Sensor Objektdaten 22 erzeugt. Die Objektdaten 22 weisen dabei Informationen zu den virtuellen Objekten 01-06 wie deren Existenz, Entfernung und Richtung auf. Die Objektdaten 22 können dabei z. B. mittels Ray Tracing gewonnen werden.

Die Objektdaten 22 gibt das Sichtbarkeits-Modul 12 einerseits an ein Abbildungs-Modul 14 und zum anderen an ein Ausgabemodul 20 ab. Die Module 12, 14 und 20 sind vorzugsweise als Softwarefunktionen ausgebildet. Es ist möglich, dass für den Ablauf dieser Funktionen eine eigene Hardware vorgesehen sein kann, insbesondere wenn sich um rechenintensive Funktionen handelt wie bspw. die Berechnung einer Fouriertransformation. Dafür können bspw. Grafikprozessoren verwendet werden.

Das Abbildungs-Modul 14 ermittelt aus den Objektdaten 22 wenigstens zwei Parameter des virtuellen Objekts 01-06 und stellt die zumindest zwei Parameter in einer ersten Zuordnungs-Abbildung 24 dar. Die erste Zuordnungs-Abbildung 24 wird an ein Verknüpfungs-Modul 16 übertragen.

Das Verknüpfungs-Modul 16 überführt die erste Zuordnungs-Abbildung 24 unter Berücksichtigung einer charakteristischen Funktion 46 des Sensors in eine zweite Zuordnungs-Abbildung 26, wobei in der zweiten Zuordnungs-Abbildung 26 das zumindest eine virtuelle Objekt 01-06 in Abhängigkeit von den zumindest zwei Parametern dargestellt ist. Die zweite Zuordnungs-Abbildung 26 wird dabei vom Verknüpfungs-Modul 16 einerseits an ein Rückberechnungs-Modul 18 ausgegeben und zum anderen an das Ausgabemodul 20.

Das Rückberechnungs-Modul 18 bestimmt aus der zweiten Zuordnungs-Abbildung 26 synthetische Sensor-Rohdaten 28, die das Rückberechnungs-Modul 18 an das Ausgabemodul 20 weitergibt. Für die Ermittlung der Sensor-Rohdaten 28 aus der zweiten Zuordnungs-Abbildung 26 kann das Rückberechnungs-Modul 18 eine inverse Fourier-Transformation verwenden.

Das Ausgabemodul 20 stellt synthetische Sensordaten 32 zur Ausgabe z. B. an die Anwendung 36 bereit. Die synthetischen Sensordaten 32 werden aus der zweiten Zuordnungs-Abbildung 26 erzeugt und umfassen dabei insbesondere die Informationen der zweiten Zuordnungs-Abbildung 26. Dabei können auch die Objektdaten 22 und/oder die synthetischen Sensor-Rohdaten 28 berücksichtigt werden. Die synthetischen Sensordaten 32 werden von dem Ausgabe-Modul 20 insbesondere so erzeugt, dass sie die Sensordaten des realen Sensors, der simuliert wird, möglichst genau nachbilden.

Die Anwendung 36, die in Abhängigkeit von den synthetischen Sensordaten 32 beispielsweise eine Trajektorie für ein Fahrzeug bestimmt, überträgt solche Anwendungsdaten 34 an die virtuelle Umgebung 30, sodass eine Relativbewegung des simulierten Sensors 38 zu den virtuellen Objekten 01-06 in der virtuellen Umgebung 30 im Zeitverlauf berücksichtigt werden kann.

Die zweite Zuordnungs-Abbildung ist dabei so ausgebildet, dass sie mit ihren Informationen einem Verarbeitungsschritt innerhalb des realen Sensors entspricht, der durch den virtuellen Sensor 38 simuliert wird. Durch die oben genannte charakteristische Funktion 46, insbesondere Punktspreizfunktion, ist es möglich, eine realistische Simulation der Signalverarbeitungskette durchzuführen, und auch das Zwischenprodukt der zweiten Zuordnungs-Abbildung 26 durch den Simulator 10 ausgeben zu können. Durch z. B. die Punktspreizfunktion ist der jeweilige Sensor in seinen Abbildungseigenschaften charakterisiert, so dass sie verwendet werden kann, um aus den Objektdaten zu der Entfernungs-Doppler-Abbildung, wie sie in dem zu simulierenden Sensor vorläge, zurückrechnen zu können.

Figur 2 zeigt, wie die in der virtuellen Umgebung 30 simulierten verschiedenen virtuelle Objekte 01-06 sich in der zweiten Zuordnungs-Abbildung 26 wiederfinden. Wie im linken Bild von Figur 2 dargestellt, sendet ein simulierter Sensor 38 Tastsignale auf die virtuelle Umgebung 30 mit den Objekten O1 bis O6 aus. Dazu kann vorzugsweise das sogenannte Ray Tracing verwendet werden.

Fahrerassistenzsysteme, die die Fahrzeugumgebung aktiv beobachten und anhand ihrer Beobachtungen das Fahrzeug ansteuern können, werden regelmäßig in virtuellen Testumgebungen entwickelt und getestet. Dabei ist der jeweilige Sensor, beispielsweise ein Radarsensor, vollständig oder teilweise durch einen virtuellen Sensor 38 ersetzt, was auch als frei geschnitten bezeichnet werden kann.

Der virtuelle Sensor 38 emuliert die Funktion des physischen realen Sensors in einer realistischen Weise und erzeugt passend zu der virtuellen Testumgebung 30 passende synthetische Sensordaten 32. Wie in Bezug auf Figur 1 beschrieben, können die synthetischen Sensordaten 32 aus der zweiten Zuordnungs-Abbildung 26 erzeugt werden. Optional können die synthetischen Sensordaten 32 zusätzlich aus den Objektdaten 22 erzeugt werden.

Die synthetischen Sensordaten 32 werden in die Anwendung 36 eingespeist. Bei der Anwendung 36 handelt es sich beispielsweise um einen Notbremsassistenten, eine Fußgängererkennung und/oder eine Anwendung zum vollautomatischen Fahren. Mit den synthetischen Sensordaten 32 kann geprüft werden, ob die Anwendung 36 auf in der virtuellen Testumgebung 30 nachgestellte Situationen wunschgemäß reagiert.

Die virtuelle Testumgebung 30 soll einen Feldtest der Anwendung 36 realistisch nachstellen. Das bedeutet, dass die gesamte Simulation inklusive der Erzeugung der synthetischen Sensordaten 32 in Echtzeit ablaufen muss. Wenn beispielsweise eine Anwendung 36 alle 30 ms neue Sensordaten erwartet, muss die Simulation alle 30 ms einen vollständigen aktuellen Satz synthetischer Sensordaten 32 bereitstellen.

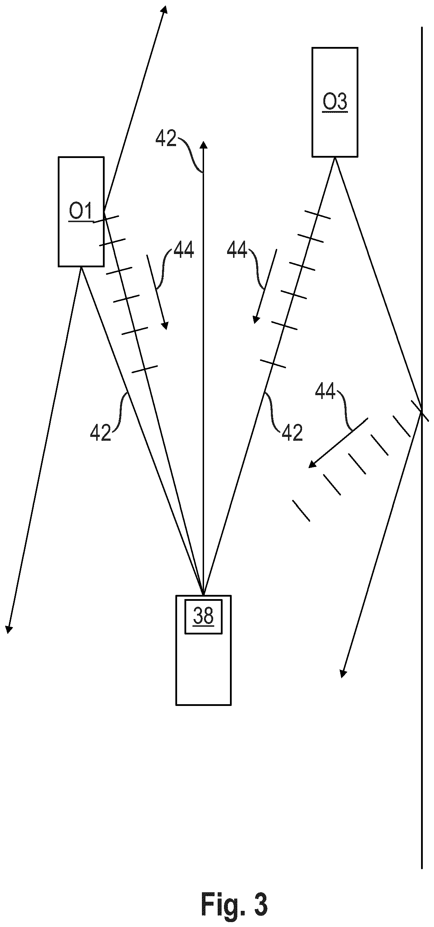

In der virtuellen Umgebung 30 sind in Figur 2 die virtuellen Objekte O1 bis O6 zu sehen, an denen simulierte Tastsignale 42, die vom simulierten Sensor 38 ausgehen, reflektiert werden (vgl. Figur 3). Die entsprechenden Wellenfronten von simulierten Echosignalen 44 (vgl. Figur 3) werden vom simulierten Sensor 38 empfangen und bestimmen die Erzeugung der Objektdaten 22, aus denen dann, wie zu Figur 1 beschrieben, die zweite Zuordnungs-Abbildung 26 ermittelt wird.

Auf der rechten Seite von Figur 2 ist die zweite Zuordnungs-Abbildung 26 abgebildet. Durch die Pfeile zwischen dem linken Bild und der zweiten Zuordnungs-Abbildung 26 sind die Positionen der Objekte O1 bis O6 in der zweiten Zuordnungs-Abbildung 26 markiert.

Auf der Abszisse dieser zweiten Zuordnungs-Abbildung 26 wird die Relativgeschwindigkeit zwischen dem simulierten Sensor 38 und dem jeweiligen virtuellen Objekt 01-06 eingetragen und auf der Ordinate die Entfernung zwischen dem simulierten Sensor 38 und dem jeweiligen Objekt 01-06. Über die Helligkeit in der zweiten Zuordnungs-Abbildung 26 kann eine dritte Dimension, nämlich wie stark das Echosignal des jeweiligen Objekts ist, dargestellt werden. Dies wird auch Peak genannt. Das kann auf die Größe des jeweiligen Objekts 01-06 deuten, aber zumindest wie stark das jeweilige Objekt 01-06 das vom Sensor 38 ausgesandte Signal reflektiert. Rechts neben der zweiten Zuordnungs-Abbildung 26 ist eine Zuordnung der Helligkeit zu Zahlenwerten angegeben.

In Figur 3 ist beispielhaft das verwendete Ray-Tracing Verfahren zur Erzeugung von Objektdaten 22 in der virtuellen Umgebung dargestellt.

Ray Tracing ist ein bekanntes Verfahren zur realistischen Darstellung optischer Phänomene in der Computergrafik. Um ein von einem virtuellen Beobachter wahrgenommenes Bild zu berechnen, wird ausgehend von dessen Augen ein Bündel geometrischer Lichtstrahlen in die virtuelle Umgebung 30 geworfen. Durch eine weitere Verfolgung einzelner Strahlen anhand von Reflexions- bzw. Brechungsgesetzen lässt sich berechnen, was der Beobachter an einer reflektierenden und oder brechenden Oberfläche sieht. Mit Grafikkarten kann eine Berechnung eines Ray Tracing-Bildes in Echtzeit ermöglicht werden.

Vorliegend ist der Beobachter der virtuelle Sensor 38 und dargestellt ist die Anpassung von Ray Tracing auf Radarwellen, also elektromagnetische Wellen im Radiofrequenzbereich. Die vom virtuellen Sensor 38 sichtbaren Polygone, also Objekte O1-O6, in der virtuellen Testumgebung 30 werden mit einem virtuellen geometrischen Strahl als simuliertes Tastsignal 42 beschossen und jeder Strahl wird nach den Gesetzen der geometrischen Optik als simuliertes Echosignal 44 reflektiert und weiterverfolgt. Aufgrund der Eigenschaften von elektromagnetischen Wellen im Radar-Bereich erfolgt die Simulation so, dass jeder Kontakt eines Radar-Strahls als simuliertem Tastsignal 42 mit einem Polygon eine lokale Wellenfront als simuliertes Echosignal 44 erzeugt. Simuliert wird jede Wellenfront als eine auf den virtuellen Sensor 38 gerichtete ebene Welle. Die Intensität dieser Welle hängt von der Entfernung der räumlichen Ausrichtung und dem Material des jeweiligen Polygons, also Objektes 01-06, ab. Das vom virtuellen Sensor 38 gemessene Echo wird als Summe aller ebenen Wellen der simulierten Echosignale 44 berechnet.

Figur 3 zeigt schematisch den simulierten Sensor 38 mit den simulierten Tastsignalen 42, dem simulierten Echosignal 44 als Wellenfront, wobei vorliegend nur die virtuellen Objekte O1 und O3 sowie eine Seitenwand gezeigt sind. Die Seitenwand kann auch eines der Objekte O1 bis O6 sein.

Das vom Sensor 38 mittig ausgesandte Tastsignal ruft keine Reflexion hervor, aber die Tastsignale, die die Objekte O1 und O3 sowie die Seitenwand rechts rufen Echosignale 44 als ebene Wellenfronten hervor (Fernfeldnäherung). Am Sensor 38 überlagern sich die Echosignale 44, wobei der simulierte Sensor 38 aus diesen Echosignalen 44 dann mittels des Sichtbarkeits-Moduls 12 die Objektdaten 22 erzeugt. Für die Bestimmung des Verlaufs der Tast- und Echosignale 42, 44 werden auf diese Weise die optischen Reflexions- und Brechungsgesetze verwendet.

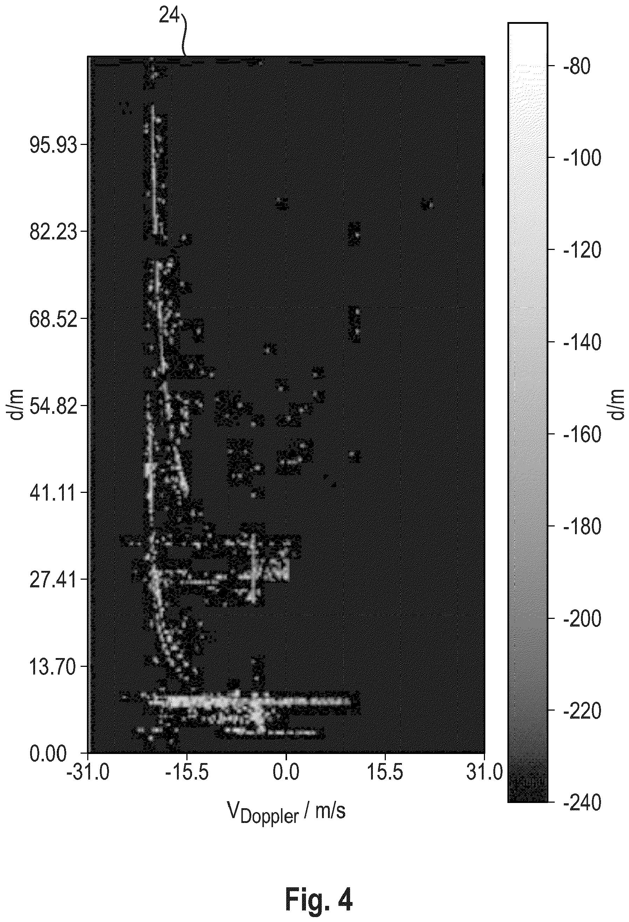

Figur 4 zeigt die erste Zuordnungs-Abbildung 24, welche als erste Entfernungs-Doppler-Abbildung 24 ausgebildet ist. Die erste Entfernungs-Doppler-Abbildung 24 zeigt die Dopplergeschwindigkeit in Metern pro Sekunde auf der Abszisse und der Entfernung in Metern zwischen dem Sensor 38 und den jeweiligen Objekten O1-O6. Eine dritte Dimension ist wiederum die Helligkeit der dargestellten Objekte O1-O6, wobei rechts wiederum eine Beziehung zwischen dieser Intensität und einem Zahlenwert dargestellt ist.

Die erste Zuordnungs-Abbildung 24 umfasst diejenigen Informationen, wie sie das Abbildungs-Modul 14 aus den Objektdaten 22 ermittelt. Es sind nur die lokalen Maxima aus der ersten Entfernungs-Doppler-Abbildung eingetragen. Diese erste Entfernungs-Doppler-Abbildung lässt sich unmittelbar erstellen, weil sämtliche dafür benötigten Informationen in den Objektdaten 22 fertig und abrufbereit vorliegen.

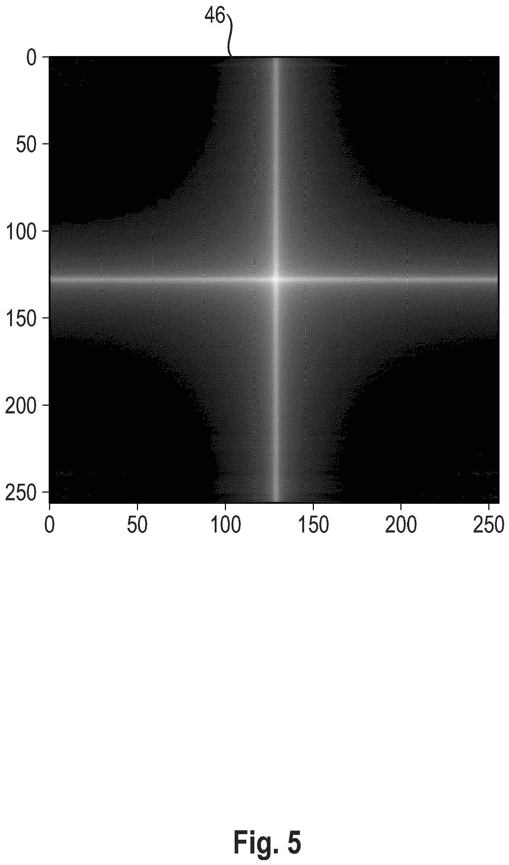

Figur 5 zeigt eine charakteristische Funktion 46 für einen Sensor, welche als Punktspreizfunktion ausgebildet ist. Bei der Punktspreizfunktion handelt es sich um eine Antwort eines Sensors auf ein ideales punktförmiges Objekt. Solch eine charakteristische Funktion 46 lässt sich für den Sensor, wie z. B. einen Radarsensor oder Lidar-Sensor, ausmessen und/oder analytisch beschreiben. Die Punktspreizfunktion beschreibt dabei, wie das jeweilige punktförmige Objekt durch den Sensor abgebildet wird.

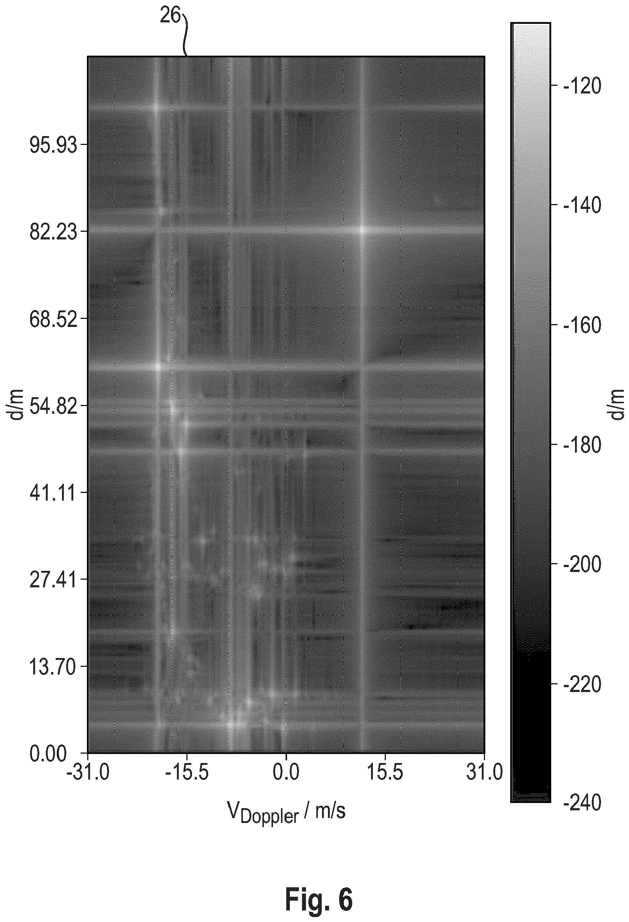

Durch eine Faltung der charakteristischen Funktion 46 von Figur 5 mit der ersten Entfernungs-Doppler-Abbildung 24 von Figur 4 wird durch das Verknüpfungs-Modul 16 die zweite Entfernungs-Doppler-Abbildung 26 von Figur 6 ermittelt. Es werden dann der ersten Entfernungs-Doppler-Abbildung 24 (Figur 4) Verschmierungen hinzugefügt, so dass damit die zweite Entfernungs-Doppler-Abbildung 26 (Figur 6) erzeugt wird.

Aus der ersten Entfernungs-Doppler-Abbildung 24 wird durch Faltung mit der charakteristischen Funktion 46 die zweite Zuordnungs-Abbildung 26 erstellt, die realitätsnah ist, da sie Abbildungseigenschaften des zu simulierenden Sensors berücksichtigt.

Figur 6 zeigt die zweite Zuordnungs-Abbildung 26 mit den gewünschten Verschmierungen der aufgetragenen Signale. Rechts ist wiederum die Übersetzung der Helligkeit der aufgetragenen Signale, der Peaks, in einen Zahlenwert dargestellt. Die erkannten Objekte 01-06 sind als hell leuchtenden lokale Maxima zu erkennen. Jedes Objekt 01-06 ist von einer kreuzförmigen Verschmierung entlang beider Achsen flankiert. Diese Verschmierungen stellen keine physikalische Realität der Sensorumgebung dar, sondern Artefakte des Sensors 38, die durch die zeitlich begrenzten Analyseintervalle der Rohdaten bei der Durchführung der Fourier-Transformationen entstehen.

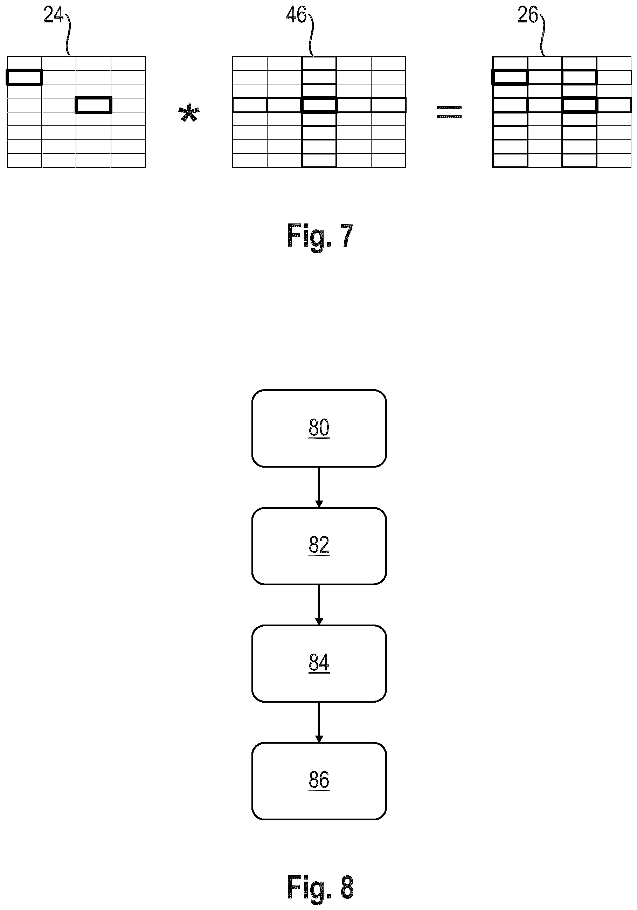

Figur 7 zeigt schematisch, wie die Faltung abläuft. Dabei wird die erste Zuordnungs-Abbildung 24 mit der charakteristischen Funktion 46 gefaltet, und es entsteht die zweite Zuordnungs-Abbildung 26 mit den entsprechenden Flächen. Klar zu sehen sind die Verschmierungen um die beiden dunklen Felder, wobei die Verschmierungen durch die Eigenschaften des Sensors 38 bedingt sind.

Figur 8 zeigt in einem Flussdiagramm das Verfahren gemäß dieser Anmeldung.

In Verfahrensschritt 80 werden die Objektdaten 22 für zumindest ein virtuelles Objekt O1 bis O6, das sich in einer virtuellen Umgebung 30 befindet, in Abhängigkeit vom Sensor 38 erzeugt. Hierfür kann z. B. ein in Bezug auf Figur 2 und Figur 3 beschriebenes Ray Tracing Verfahren verwendet werden. Dieser Verfahrensschritt 80 wird z. B. durch das Sichtbarkeits-Modul 12 ausgeführt.

In Verfahrensschritt 82 werden zumindest zwei Parameter des wenigstens einen virtuellen Objektes 01-06 ermittelt, und zwar aus den Objektdaten 22. Die virtuellen Objekte 01-06 werden dann in Abhängigkeit von den zumindest zwei Parametern in der ersten Zuordnungs-Abbildung 24 dargestellt. Dieser Verfahrensschritt 82 wird z. B. durch das Abbildungs-Modul 14 ausgeführt.

In Verfahrensschritt 84 erfolgt ein Überführen der ersten Zuordnungs-Abbildung 24 unter Berücksichtigung einer charakteristischen Funktion 46 des Sensors 38 in die zweite Zuordnungs-Abbildung 26, wobei in der zweiten Zuordnungs-Abbildung 26 das zumindest eine virtuelle Objekt 01-06 in Abhängigkeit von den zumindest zwei Parametern dargestellt ist. Dieser Verfahrensschritt 84 wird z. B. durch das Verknüpfungs-Modul 16 ausgeführt.

In Verfahrensschritt 86 erfolgt das Konvertieren der zweiten Zuordnungs-Abbildung 26 in synthetische Sensordaten 32 und ein Bereitstellen der synthetischen Sensordaten 32 zur Ausgabe. Dieser Verfahrensschritt 86 wird z. B. durch das Ausgabe-Modul 20 ausgeführt.

### Bezugszeichenliste

- 10: Simulator
- 12: Sichtbarkeits-Modul
- 14: Abbildungs-Modul
- 16: Verknüpfungs-Modul
- 18: Rückberechnungs-Modul
- 20: Ausgabe-Modul
- 22: Objektdaten
- 24: erste Zuordnungs-Abbildung
- 26: zweite Zuordnungs-Abbildung
- 28: synthetische Sensor-Rohdaten
- 30: virtuelle Umgebung
- 32: synthetische Sensordaten
- 34: Anwendungsdaten
- 36: Anwendung
- 38: simulierter Sensor
- 40: Simulationsumgebung
- 42: simuliertes Tastsignal
- 44: simuliertes Echosignal als Wellenfront
- 46: charakteristische Funktion
- 80-86: Verfahrensschritte
- 01-06: virtuelle Objekte

## Patentansprüche

1. Simulator (10) zur Simulation eines Sensors zur Objekterfassung, wobei der Simulator (10) eingerichtet ist, mittels der Simulation synthetische Sensordaten (32) des Sensors zu erzeugen, wobei der Simulator (10) aufweist:
ein Sichtbarkeits-Modul (12), das eingerichtet ist, für zumindest ein virtuelles Objekt (01-06), das sich in einer virtuellen Umgebung (30) befindet, in Abhängigkeit von dem Sensor Objektdaten (22) zu erzeugen,
ein Abbildungs-Modul (14), das eingerichtet ist, zumindest zwei Parameter des virtuellen Objektes (01-06) aus den Objektdaten (22) zu ermitteln und das zumindest eine virtuelle Objekt (01-06) in Abhängigkeit von den zumindest zwei Parametern in einer ersten Zuordnungs-Abbildung (24) darzustellen,
ein Verknüpfungs-Modul (16), das eingerichtet ist, die erste Zuordnungs-Abbildung (24) unter Berücksichtigung einer charakteristischen Funktion (46) des Sensors in eine zweite Zuordnungs-Abbildung (26) zu überführen, wobei in der zweiten Zuordnungs-Abbildung (26) das zumindest eine virtuelle Objekt (01-06) in Abhängigkeit von den zumindest zwei Parametern dargestellt ist,
ein Ausgabe-Modul (20), das eingerichtet ist, die zweite Zuordnungs-Abbildung (26) in die synthetischen Sensordaten (32) zu konvertieren und die synthetischen Sensordaten (32) zur Ausgabe bereitzustellen.

2. Simulator nach Anspruch 1, wobei die erste Zuordnungs-Abbildung (24) eine erste Entfernungs-Doppler-Abbildung aufweist und die zweite Zuordnungs-Abbildung (26) eine zweite Entfernungs-Doppler-Abbildung aufweist.

3. Simulator nach einem der vorhergehenden Ansprüche, wobei die charakteristische Funktion (46) eine Punktspreizfunktion des Sensors aufweist und das Verknüpfungs-Modul (16) eingerichtet ist, die erste Zuordnungs-Abbildung (24) unter Ausführung einer Faltungsfunktion mit der Punktspreizfunktion (46) in die zweite Zuordnungs-Abbildung (26) zu überführen, wobei die Faltungsfunktion insbesondere eine Faltung umfasst.

4. Simulator nach einem der vorhergehenden Ansprüche, wobei der Sensor zur Objekterfassung einen aktiven Sensor aufweist, welcher eingerichtet ist, Sensor-Rohdaten durch Aussenden eines Tastsignals und Empfangen eines Echosignals zu erzeugen und die zweite Zuordnungs-Abbildung (26) aus den Sensor-Rohdaten zu ermitteln.

5. Simulator nach Anspruch 4, weiter aufweisend ein Rückberechnungs-Modul (18), das eingerichtet ist, aus der zweiten Zuordnungs-Abbildung (26) synthetische Sensor-Rohdaten (28) zu ermitteln, wobei die Ermittlung der synthetischen Sensor-Rohdaten (28) von dem Sensor zur Objekterfassung abhängt.

6. Simulator nach Anspruch 5, wobei die Ermittlung der synthetischen Sensor-Rohdaten (28) durch das Rückberechnungs-Modul (18) eine inverse Fourier-Transformation aufweist.

7. Simulator nach einem der vorhergehenden Ansprüche, wobei dem simulierten Sensor (38) in der virtuellen Umgebung (30) eine virtuelle Position zugeordnet ist und das Sichtbarkeits-Modul (12) eingerichtet ist, die Objektdaten (22) für das zumindest eine virtuelle Objekt (01-06) zyklisch unter Berücksichtigung der jeweiligen virtuellen Position zu erzeugen.

8. Simulator nach Anspruch 7, wobei die Objektdaten (22) für ein jeweiliges virtuelles Objekt (01-06) eine Repräsentation eines jeweiligen virtuellen Echosignals (44) eines jeweiligen virtuellen Tastsignals (42) an dem jeweiligen virtuellen Objekt (01-06) aufweisen.

9. Simulator nach einem der vorhergehenden Ansprüche, wobei die synthetischen Sensordaten (32) so ausgebildet sind, dass durch den Sensor daraus die Objektdaten (22) herleitbar sind.

10. Verfahren zur Simulation eines Sensors zur Objekterfassung, wobei die Simulation synthetische Sensordaten (32) des Sensors erzeugt, mit folgenden Verfahrensschritten:
Erzeugen von Objektdaten (22) für zumindest ein virtuelles Objekt (01-06), das sich in einer virtuellen Umgebung (30) befindet, in Abhängigkeit vom Sensor,
Ermitteln von zumindest zwei Parametern des virtuellen Objektes (01-06) aus den Objektdaten (22) und Darstellen des zumindest einen virtuellen Objektes (01-06) in Abhängigkeit von den zumindest zwei Parametern in einer ersten Zuordnungs-Abbildung (24),
Überführen der ersten Zuordnungs-Abbildung (24) unter Berücksichtigung einer charakteristischen Funktion (46) des Sensors in eine zweite Zuordnungs-Abbildung (26), wobei in der zweiten Zuordnungs-Abbildung (26) das zumindest eine virtuelle Objekt (01-06) in Abhängigkeit von den zumindest zwei Parametern dargestellt ist,
Konvertieren der zweiten Zuordnungs-Abbildung (26) in die synthetischen Sensordaten (32) und Bereitstellen der synthetischen Sensordaten (32) zur Ausgabe.

11. Verfahren nach Anspruch 10, wobei die erste Zuordnungs-Abbildung (24) eine erste Entfernungs-Doppler-Abbildung aufweist und die zweite Zuordnungs-Abbildung (26) eine zweite Entfernungs-Doppler-Abbildung aufweist.

12. Verfahren nach Anspruch 10 oder 11, wobei die charakteristische Funktion (46) eine Punktspreizfunktion des Sensors aufweist und die erste Zuordnungs-Abbildung (24) unter Ausführung einer Faltungsfunktion mit der Punktspreizfunktion in die zweite Zuordnungs-Abbildung (26) überführt wird, wobei die Faltungsfunktion insbesondere eine Faltung aufweist.

13. Verfahren nach einem der Ansprüche 10 bis 12, wobei der Sensor zur Objekterfassung einen aktiven Sensor aufweist, welcher eingerichtet ist, Sensor-Rohdaten durch Aussenden eines Tastsignals und Empfangen eines Echosignals zu erzeugen und die zweite Zuordnungs-Abbildung aus den Sensor-Rohdaten zu ermitteln.

14. Verfahren nach einem der Ansprüche 10 bis 13, wobei dem simulierten Sensor (38) in der virtuellen Umgebung (30) eine virtuelle Position zugeordnet ist und die Objektdaten (22) für das zumindest eine virtuelle Objekt (O1-O6) zyklisch unter Berücksichtigung der jeweiligen virtuellen Position erzeugt werden.

15. Computerprogrammprodukt, umfassend die Befehle, die bei der Ausführung eines Programms durch einen Computer, diesen veranlassen, die Schritte des Verfahrens nach einem der Ansprüche 10 bis 14 auszuführen.

## Geänderte Patentansprüche

### Geänderte Patentansprüche gemäss Regel 137(2) EPÜ.

1. Simulator (10) zur Simulation eines Sensors zur Objekterfassung, wobei der Simulator (10) eingerichtet ist, mittels der Simulation synthetische Sensordaten (32) des Sensors zu erzeugen, wobei der Simulator (10) aufweist:
ein Sichtbarkeits-Modul (12), das eingerichtet ist, für zumindest ein virtuelles Objekt (01-06), das sich in einer virtuellen Umgebung (30) befindet, in Abhängigkeit von dem Sensor Objektdaten (22) zu erzeugen,
ein Abbildungs-Modul (14), das eingerichtet ist, zumindest zwei Parameter des virtuellen Objektes (01-06) aus den Objektdaten (22) zu ermitteln und das zumindest eine virtuelle Objekt (01-06) in Abhängigkeit von den zumindest zwei Parametern in einer ersten Zuordnungs-Abbildung (24) darzustellen,
ein Verknüpfungs-Modul (16), das eingerichtet ist, die erste Zuordnungs-Abbildung (24) unter Berücksichtigung einer charakteristischen Funktion (46) des Sensors in eine zweite Zuordnungs-Abbildung (26) zu überführen, wobei in der zweiten Zuordnungs-Abbildung (26) das zumindest eine virtuelle Objekt (01-06) in Abhängigkeit von den zumindest zwei Parametern dargestellt ist,
ein Rückberechnungs-Modul (18), das eingerichtet ist, aus der zweiten Zuordnungs-Abbildung (26) synthetische Sensor-Rohdaten (28) zu ermitteln, wobei die Ermittlung der synthetischen Sensor-Rohdaten (28) von dem Sensor zur Objekterfassung abhängt und eine inverse Fourier-Transformation aufweist,
ein Ausgabe-Modul (20), das eingerichtet ist, die die synthetischen Sensor-Rohdaten (32) zur Ausgabe bereitzustellen.

2. Simulator nach Anspruch 1, wobei die erste Zuordnungs-Abbildung (24) eine erste Entfernungs-Doppler-Abbildung aufweist und die zweite Zuordnungs-Abbildung (26) eine zweite Entfernungs-Doppler-Abbildung aufweist.

3. Simulator nach einem der vorhergehenden Ansprüche, wobei die charakteristische Funktion (46) eine Punktspreizfunktion des Sensors aufweist und das Verknüpfungs-Modul (16) eingerichtet ist, die erste Zuordnungs-Abbildung (24) unter Ausführung einer Faltungsfunktion mit der Punktspreizfunktion (46) in die zweite Zuordnungs-Abbildung (26) zu überführen, wobei die Faltungsfunktion insbesondere eine Faltung umfasst.

4. Simulator nach einem der vorhergehenden Ansprüche, wobei der Sensor zur Objekterfassung einen aktiven Sensor aufweist, welcher eingerichtet ist, Sensor-Rohdaten durch Aussenden eines Tastsignals und Empfangen eines Echosignals zu erzeugen und die zweite Zuordnungs-Abbildung (26) aus den Sensor-Rohdaten zu ermitteln.

5. Simulator nach einem der vorhergehenden Ansprüche, wobei dem simulierten Sensor (38) in der virtuellen Umgebung (30) eine virtuelle Position zugeordnet ist und das Sichtbarkeits-Modul (12) eingerichtet ist, die Objektdaten (22) für das zumindest eine virtuelle Objekt (01-06) zyklisch unter Berücksichtigung der jeweiligen virtuellen Position zu erzeugen.

6. Simulator nach Anspruch 5, wobei die Objektdaten (22) für ein jeweiliges virtuelles Objekt (01-06) eine Repräsentation eines jeweiligen virtuellen Echosignals (44) eines jeweiligen virtuellen Tastsignals (42) an dem jeweiligen virtuellen Objekt (01-06) aufweisen.

7. Simulator nach einem der vorhergehenden Ansprüche, wobei die synthetischen Sensordaten (32) so ausgebildet sind, dass durch den Sensor daraus die Objektdaten (22) herleitbar sind.

8. Verfahren zur Simulation eines Sensors zur Objekterfassung, wobei die Simulation synthetische Sensordaten (32) des Sensors erzeugt, mit folgenden Verfahrensschritten:
Erzeugen von Objektdaten (22) für zumindest ein virtuelles Objekt (01-06), das sich in einer virtuellen Umgebung (30) befindet, in Abhängigkeit vom Sensor,
Ermitteln von zumindest zwei Parametern des virtuellen Objektes (01-06) aus den Objektdaten (22) und Darstellen des zumindest einen virtuellen Objektes (01-06) in Abhängigkeit von den zumindest zwei Parametern in einer ersten Zuordnungs-Abbildung (24),
Überführen der ersten Zuordnungs-Abbildung (24) unter Berücksichtigung einer charakteristischen Funktion (46) des Sensors in eine zweite Zuordnungs-Abbildung (26), wobei in der zweiten Zuordnungs-Abbildung (26) das zumindest eine virtuelle Objekt (01-06) in Abhängigkeit von den zumindest zwei Parametern dargestellt ist,
Ermitteln von synthetischen Sensor-Rohdaten (28) aus der zweiten Zuordnungs-Abbildung, wobei die Ermittlung der synthetischen Sensor-Rohdaten (28) von dem Sensor zur Objekterfassung abhängt und eine inverse Fourier-Transformation aufweist,
und Bereitstellen der synthetischen Sensor-Rohdaten (32) zur Ausgabe.

9. Verfahren nach Anspruch 8, wobei die erste Zuordnungs-Abbildung (24) eine erste Entfernungs-Doppler-Abbildung aufweist und die zweite Zuordnungs-Abbildung (26) eine zweite Entfernungs-Doppler-Abbildung aufweist.

10. Verfahren nach Anspruch 8 oder 9, wobei die charakteristische Funktion (46) eine Punktspreizfunktion des Sensors aufweist und die erste Zuordnungs-Abbildung (24) unter Ausführung einer Faltungsfunktion mit der Punktspreizfunktion in die zweite Zuordnungs-Abbildung (26) überführt wird, wobei die Faltungsfunktion insbesondere eine Faltung aufweist.

11. Verfahren nach einem der Ansprüche 8 bis 10, wobei der Sensor zur Objekterfassung einen aktiven Sensor aufweist, welcher eingerichtet ist, Sensor-Rohdaten durch Aussenden eines Tastsignals und Empfangen eines Echosignals zu erzeugen und die zweite Zuordnungs-Abbildung aus den Sensor-Rohdaten zu ermitteln.

12. Verfahren nach einem der Ansprüche 8 bis 11, wobei dem simulierten Sensor (38) in der virtuellen Umgebung (30) eine virtuelle Position zugeordnet ist und die Objektdaten (22) für das zumindest eine virtuelle Objekt (O1-O6) zyklisch unter Berücksichtigung der jeweiligen virtuellen Position erzeugt werden.

13. Computerprogrammprodukt, umfassend die Befehle, die bei der Ausführung eines Programms durch einen Computer, diesen veranlassen, die Schritte des Verfahrens nach einem der Ansprüche 8 bis 12 auszuführen.
